# EUROPEAN PATENT APPLICATION

(11) **EP 2 120 257 A1**
(43) Date of publication of application: **18.11.2009**
(21) Application number: 09703270.0
(22) Date of filing: 12.02.2009
(51) Int. Cl.: H01L 21/306, H01L 21/3065, H01L 33/00, H01S 5/22, H01S 5/323

(54) **METHOD FOR MANUFACTURING SEMICONDUCTOR ELEMENT**

(30) Priority: 22.07.2008 JP 2008188718
(71) Applicant: Sumitomo Electric Industries, Ltd., Chuo-ku Osaka-shi Osaka 541-0041 (JP)
(72) Inventor: KITABAYASHI, Hiroyuki, Osaka-shi Osaka 554-0024 (JP); KATAYAMA, Koji, Itami-shi Hyogo 664-0016 (JP); ARAKAWA, Satoshi, Itami-shi Hyogo 664-0016 (JP)
(74) Representative: Grünecker, Kinkeldey, Stockmair & Schwanhäusser Anwaltssozietät
(86) International application number: PCT/JP2009/052260
(87) International publication number: WO 2009/093762

(57) **Abstract**

A method for manufacturing a semiconductor device according to the present invention includes the following step: a step (S10) of forming a GaN-based semiconductor layer, a step (S20) of forming an Al film on the GaN-based semiconductor layer, a step (S30, S40) of forming a mask layer composed of a material having a lower etching rate than that of the material constituting the Al film, a step (S50) of partially removing the Al film and the GaN-based semiconductor layer using the mask layer as a mask to form a ridge portion, a step (S60) of retracting the positions of the side walls at the ends of the Al film from the positions of the side walls of the mask layer, a step (S70) of forming a protection film composed of a material having a lower etching rate than that of the material constituting the Al film on the side surfaces of the ridge portion and on the upper surface of the mask layer, and a step (S80) of removing the Al film to remove the mask layer and the protection film formed on the upper surface of the mask layer.

## Description

### Technical Field

The present invention relates to a method for manufacturing a semiconductor device, and more specifically to a method for manufacturing a semiconductor device including a gallium nitride-based semiconductor layer.

### Background Art

A semiconductor device having a ridge structure formed in a gallium nitride-based semiconductor layer has been known. As a method for forming such a ridge structure in a semiconductor device, various methods have been proposed.

For example, Patent No. 3604278 (referred to as "Patent Document 1" hereinafter) discloses that a ridge structure is formed in a gallium nitride-based semiconductor layer by dry etching using as a mask a first protection film composed of silicon oxide or a photoresist film. After the dry etching, a second protection film composed of a material different from that of the first protection film is formed to cover the formed ridge portion (stripe-shaped waveguide), and the first protection film used as the mask for forming the ridge portion is removed with hydrofluoric acid to expose the upper surface of the ridge portion, which is to be in contact with an electrode. The second protection film covers the side surfaces of the ridge portion, and as the constituent material thereof, oxides of Ti, V, Zr, Nb, Hf, and Ta, BN, SiC, AlN, and the like are suggested.

Patent No. 3723434 (referred to as "Patent Document 2" hereinafter) discloses that the second protection film has a multi-layer film structure including a nitride film as a layer in contact with a ridge portion, and an oxide film as a layer most away from the ridge portion. Patent Document 2 also discloses a structure in which an electrode is formed only on the upper surface of a ridge portion.

As a method for forming the ridge portion and the protection film which covers the side surfaces of the ridge portion, Japanese Unexamined Patent Application Publication No. 2004-119772 (referred to as "Patent Document 3" hereinafter) discloses the following method: First, a two-layer film including a SiO₂ film and a ZrO₂ film is formed as the first protection film on a gallium nitride-based semiconductor layer, and the first protection film is heat-treated in an oxygen atmosphere to make the ZrO₂ film resistant to etching with ammonium fluoride. Then, the first protection including the film SiO₂ film and the ZrO₂ film is partially removed by reactive ion etching (RIE) to form a pattern of the ridge portion in the first protection film. Then, the gallium nitride-based semiconductor layer is partially removed by dry etching with etching gas containing chlorine gas using the first protection film as a mask to form the ridge portion. Then, the sample is immersed in an ammonium fluoride solution to retract the side wall of the SiO₂ film disposed below the first protection film by etching. Since the heat-treatment makes the ZrO₂ film resistant to etching with ammonium fluoride, only the SiO₂ film can be selectively etched. Then, a ZrO₂ film is formed as a second protection film by an electron-beam evaporation method or sputter deposition method so as to cover the first protection film and the whole of the ridge portion. In this step, since the side wall of the SiO₂ film constituting the first protection film is retracted, the ZrO₂ film as the second protection film is not deposited on the side wall of the SiO₂ film. Then, the SiO₂ film constituting the first protection film is removed with ammonium fluoride, and at the same time, the ZrO₂ film disposed on the SiO₂ film is removed. As a result, the side wall of the ridge portion is covered with the ZrO₂ film as the second protection film, and the upper surface of the ridge portion is exposed so that an electrode can be formed on the upper surface.
Patent Document 1: Patent No. 3604278
Patent Document 2: Patent No. 3723434
Patent Document 3: Japanese Unexamined Patent Application Publication No. 2004-119772

### Disclosure of Invention

### Problems to be Solved by the Invention

The above-mentioned conventional methods for manufacturing a semiconductor device have the problems below. Namely, in the manufacturing method disclosed in Patent Document 1, the first protection film is removed with hydrofluoric acid in the state where the second protection film is formed, and thus a portion of the second protection film, which is positioned on the upper surface of the ridge portion is removed (the second protection film is removed by a liftoff process). However, in this case, the second protection film may not be completely removed from the upper surface of the ridge portion, leaving a portion of the second protection film as burr. In this case, even when an electrode is formed on the upper surface of the ridge portion, contact between the upper surface of the ridge portion and the electrode may become defective, thereby decreasing the manufacture yield of a semiconductor device. In this case, it is difficult to decrease the manufacturing cost of a semiconductor device.

In addition, as in Patent Document 2, in the case in which an electrode is formed only on the upper surface of the ridge portion, when an etching mask pattern is formed for forming the electrode, it is necessary to allow the position of the mask pattern to precisely coincide with the position of the upper surface of the ridge portion. However, such positioning becomes difficult as the size of the ridge portion decreases. When the position of the mask pattern deviates from the position of the ridge portion, the position of the electrode deviates from the position of the upper surface of the ridge portion, thereby decreasing the manufacture yield of a semiconductor device. Consequently, it is difficult to decrease the manufacturing cost of a semiconductor device.

Further, in Patent Document 3, heat treatment in an oxygen atmosphere is required for enhancing the resistance of the ZrO₂ film constituting the first protection film to ammonium fluoride (making the ZrO₂ film resistant to etching with ammonium fluoride), and thus the need for heat treatment makes it difficult to decrease the manufacturing cost of a semiconductor device.

The present invention has been achieved for solving the above-described problem, and an object of the present invention is to provide a method for manufacturing a semiconductor device, which is capable of decreasing the manufacturing cost.

### Means for Solving the Problems

In a method for manufacturing a semiconductor device according to the present invention, the following steps are carried out. First, a step of preparing a gallium nitride-based semiconductor layer which constitutes a semiconductor device is carried out. A step of forming a first film on the gallium nitride-based semiconductor layer is carried out. A step of forming a second film having a pattern and composed of a material having a lower etching rate with an alkaline etchant than that of the material constituting the first film is carried out. A step of partially removing by etching the first film and the gallium nitride-based semiconductor layer using the second film as a mask to form a ridge portion in the gallium nitride-based semiconductor layer in a region below the second film is carried out. A step of removing the ends of the first film, which are positioned on the ridge portion, by etching with an alkaline etchant to retract the end positions of the first film from the end positions of the second film is carried out. A step of forming a protection film composed of a material having a lower etching rate with an alkaline etchant than that of the material constituting the first film on the side surfaces of the ridge portion and on the upper surface of the second film is carried out. A step of removing the first film by etching with an alkaline etchant to remove the second film and the protection film formed on the upper surface of the second film is carried out. A step of forming an electrode on the surface of the ridge portion exposed by removing the first film is carried out.

In a method for manufacturing a semiconductor device according to the present invention, the following steps are carried out. First, a step of preparing a gallium nitride-based semiconductor layer which constitutes a semiconductor device is carried out. A step of forming a first film on the gallium nitride-based semiconductor layer is carried out. A step of forming a second film having a pattern and composed of a material having a lower etching rate with a mixed acid than that of the material constituting the first film is carried out, the mixed acid containing phosphoric acid, nitric acid, acetic acid, and water. A step of partially removing by etching the first film and the gallium nitride-based semiconductor layer using the second film as a mask to form a ridge portion in the gallium nitride-based semiconductor layer in a region below the second film is carried out. A step of removing the ends of the first film, which are positioned on the ridge portion, by etching with a mixed acid to retract the end position of the first film from the end position of the second film, is carried out. A step of forming a protection film composed of a material having a lower etching rate with a mixed acid than that of the material constituting the first film on the side surfaces of the ridge portion and on the upper surface of the second film is carried out. A step of removing the first film by etching with a mixed acid to remove the second film and the protection film formed on the upper surface of the second film is carried out. A step of forming an electrode on the surface of the ridge portion exposed by removing the first film is carried out.

As a result, the second film is used as the mask for forming the ridge portion, and at the same time, the second film (the protection film is formed on the upper surface thereof) is removed by removing the first film in order to expose the upper surface of the ridge portion. Therefore, the protection film can be securely removed from the upper surface of the ridge portion. Thus, the possibility of deviation between the position of the upper surface of the ridge portion and the position of a portion of the protection film, which is to be removed, can be decreased as compared with the case in which in order to remove the protection film from the upper surface of the ridge portion, a new resist pattern is formed separately from the mask used for forming the ridge portion. Therefore the occurrence of a problem is able to be prevented, wherein the problem is that a connection position of the electrode is deviated from a design position due to deviation between the position of the upper surface of the ridge portion and the position of a portion of the protection film, which is to be removed, thereby causing deterioration of the characteristics and malfunction of a semiconductor device, Consequently, it is possible to suppress an increase in manufacturing cost due to a decrease in manufacture yield of a semiconductor device.

In addition, since the ends of the first film are retracted from the end position of the second film before the protection film is formed, it is possible to decrease the possibility that when the protection film is formed, a part of the protection film is formed on the end surfaces of the first film. Therefore, it is possible to decrease the event probability of the problem that, when the first film is removed, the first film cannot be sufficiently removed due to the formation of the protection film on the end surfaces of the first film (therefore, the second film, and the protection film formed on the upper surface of the second film cannot be sufficiently removed). Thus, it is possible to reduce the event probability of malfunction of a semiconductor device due to the above-described problem. Consequently, it is possible to suppress an increase in manufacturing cost due to a decrease in manufacture yield of a semiconductor device.

Further, since the second film is composed of a material having a lower etching rate with an alkaline etchant or mixed acid than that of the material constituting the first film, there is no need for additional treatment such as heat treatment for selectively etching the first film over the second film. Therefore, the number of steps for manufacturing a semiconductor device can be decreased as compared with the case in which the additional treatment is performed. As a result, the manufacturing cost of a semiconductor device can be decreased.

### Advantages

According to the present invention, the manufacturing cost of a semiconductor device can be decreased by preventing decrease in manufacturing yield.

### Brief Description of Drawings

[Fig. 1] Figure 1 is a flowchart showing a method for manufacturing a compound semiconductor device according to Embodiment 1 of the present invention.
[Fig. 2] Figure 2 is a schematic sectional view for illustrating each of the steps of the method for manufacturing a compound semiconductor device shown in Fig. 1.
[Fig. 3] Figure 3 is a schematic sectional view for illustrating each of the steps of the method for manufacturing a compound semiconductor device shown in Fig. 1.
[Fig. 4] Figure 4 is a schematic sectional view for illustrating each of the steps of the method for manufacturing a compound semiconductor device shown in Fig. 1.
[Fig. 5] Figure 5 is a schematic sectional view for illustrating each of the steps of the method for manufacturing a compound semiconductor device shown in Fig. 1.
[Fig. 6] Figure 6 is a schematic sectional view for illustrating each of the steps of the method for manufacturing a compound semiconductor device shown in Fig. 1.
[Fig. 7] Figure 7 is a schematic sectional view for illustrating each of the steps of the method for manufacturing a compound semiconductor device shown in Fig. 1.
[Fig. 8] Figure 8 is a schematic sectional view for illustrating each of the steps of the method for manufacturing a compound semiconductor device shown in Fig. 1.
[Fig. 9] Figure 9 is a schematic sectional view for illustrating each of the steps of the method for manufacturing a compound semiconductor device shown in Fig. 1.
[Fig. 10] Figure 10 is a schematic sectional view for illustrating each of the steps of the method for manufacturing a compound semiconductor device shown in Fig. 1.
[Fig. 11] Figure 11 is a schematic sectional view for illustrating each of the steps of the method for manufacturing a compound semiconductor device shown in Fig. 1.
[Fig. 12] Figure 12 is a schematic sectional view for illustrating a method for manufacturing a compound semiconductor device according to Embodiment 2 of the present invention.
[Fig. 13] Figure 13 is a schematic sectional view for illustrating each of the steps of a method for manufacturing a compound semiconductor device according to Embodiment 4 of the present invention.
[Fig. 14] Figure 14 is a schematic sectional view for illustrating each of the steps of the method for manufacturing a compound semiconductor device according to Embodiment 4 of the present invention.
[Fig. 15] Figure 15 is a schematic sectional view for illustrating each of the steps of the method for manufacturing a compound semiconductor device according to Embodiment 4 of the present invention.
[Fig. 16] Figure 16 is a schematic sectional view for illustrating each of the steps of the method for manufacturing a compound semiconductor device according to Embodiment 4 of the present invention.
[Fig. 17] Figure 17 is a schematic sectional view for illustrating each of the steps of the method for manufacturing a compound semiconductor device according to Embodiment 4 of the present invention.
[Fig. 18] Figure 18 is a schematic sectional view for illustrating each of the steps of the method for manufacturing a compound semiconductor device according to Embodiment 4 of the present invention.
[Fig. 19] Figure 19 is a schematic sectional view for illustrating each of the steps of the method for manufacturing a compound semiconductor device according to Embodiment 4 of the present invention.

### Best Mode for Carrying Out the Invention

Embodiments of the present invention are described below on the basis of the drawings. In the drawings, the same portion or corresponding portions are denoted by the same reference numeral, and description thereof is not repeated.

### (Embodiment 1)

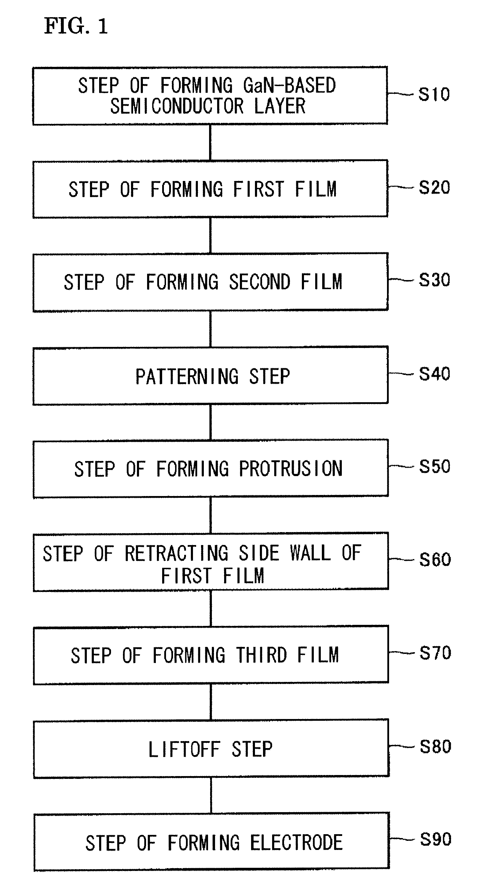

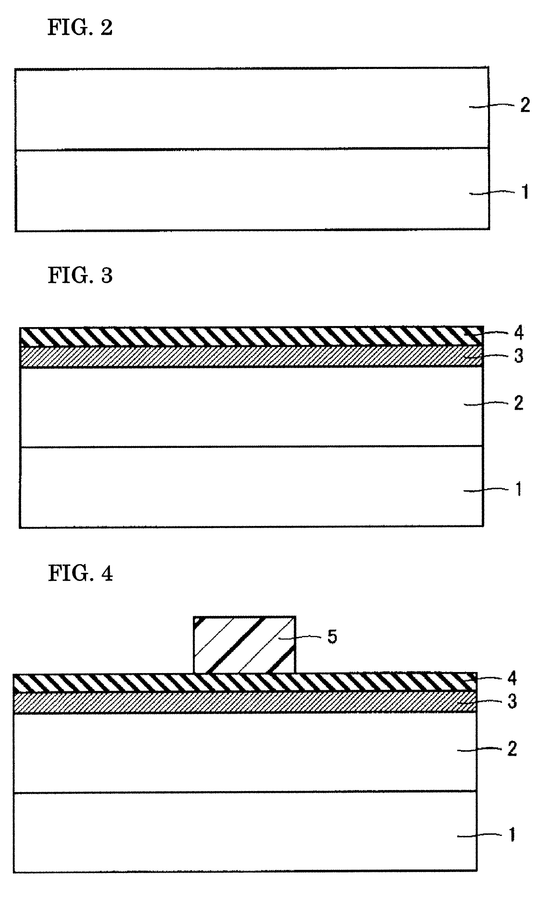

Figure 1 is a flowchart showing a method for manufacturing a compound semiconductor device according to Embodiment 1 of the present invention. Figures 2 to 11 are schematic sectional views for illustrating each of the steps of the method for manufacturing a compound semiconductor device shown in Fig. 1. A method for manufacturing a compound semiconductor device according to the present invention is described with reference to Figs. 1 to 11.

In the method for manufacturing a compound semiconductor device according to the present invention, as shown in Fig. 1, fist, a step (S10) of forming a GaN-based semiconductor layer is performed. In this step (S10), as shown in Fig. 2, a GaN-based semiconductor layer 2 is formed on the front surface of a substrate 1 using an epitaxial growth method. In this step, as the substrate 1, a substrate which permits a GaN-based semiconductor layer to be formed on the front surface thereof, for example, a substrate composed of GaN, sapphire, or the like, can be used. As a structure of the GaN-based semiconductor layer 2, a layered structure including a plurality of GaN-based semiconductor layers can be used according to the required characteristics of a compound semiconductor device to be formed. For example, when a semiconductor laser device is formed as the semiconductor device, in the case of using a GaN substrate as the substrate 1, a structure can be used as the structure of the GaN-based semiconductor layer 2, in which a p-type cladding layer and an n-type cladding layer are formed, and an active layer is sandwiched between the n-type and p-type cladding layers. As the GaN (gallium nitride)-based semiconductor layer 2, a semiconductor layer with any composition can be used as long as the composition of the semiconductor layer contains gallium (Ga) and nitrogen (N).

Next, a step (S20) of forming a first film is performed. In this step (S20), an aluminum film (Al film 3) is formed as the first film on the GaN-based semiconductor layer 2. The Al film 3 can be formed by any desired method, for example, an evaporation method, a sputter deposition method, or the like. The thickness of the Al film 3 as the first film can be, for example, 0.05 µm to 1 µm. The reason for setting the lower limit of the thickness of the Al film 3 to 0.05 µm is that when the thickness of the Al film 3 is 0.05 µm or more, liftoff of a mask layer 14 and the like can be performed without a problem in a liftoff step (S80) which will be described below.

Next, as shown in Fig. 1, a step (S30) of forming a second film is performed. In this step (S30), a silicon oxide film (SiO₂ film 4) is formed as the second film on the Al film 3. As a result, a structure as shown in Fig. 3 is obtained. The SiO₂ film 4 can be formed by any method, for example, a CVD (Chemical Vapor Deposition) method, an EB (Electron Beam) evaporation method, a sputtering method, or the like. The thickness of the SiO₂ film 4 as the first film can be, for example, 0.1 µm to 1 µm. The reason for setting the lower limit of the thickness of the SiO₂ film 4 to 0.1 µm is that during etching in a protrusion forming step (S50), the minimum thickness for leaving the SiO₂ film 4 up to the completion of etching is 0.1 µm. The reason for setting the upper limit of the thickness of the SiO₂ film 4 to 1 µm is that in a patterning step (S40), the upper limit of the thickness which permits patterning of the SiO₂ film 4 to be finished before a resist film 5 disappears is 1 µm.

Next, as shown in Fig. 1, the patterning step (S40) is performed. In this step (S40), first, a resist film is formed on the surface of the SiO₂ film 4. Then, a predetermined pattern is transferred to the resist film by a photolithographic method. Then, development is performed to form the resist film 5 having the predetermined pattern on the SiO₂ film 4 as shown in Fig. 4. The planar shape of the resist film 5 corresponds to the planar shape of the upper surface of a ridge portion described below.

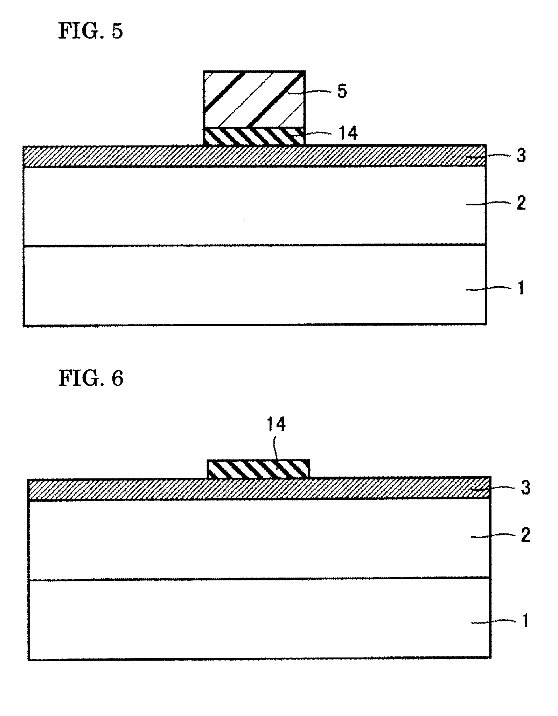

Next, as shown in Fig. 1, the step (S50) of forming a protrusion is performed. In this step (S50), the SiO₂ film 4 is partially removed by etching using the resist film 5 as a mask to form a structure as shown in Fig. 5. Namely, a mask layer 14 composed of the SiO₂ film 4 (refer to Fig. 4) is formed below the resist film 5 by etching. The planar shape of the mask layer 14 is the same as that of the resist film 5. In etching the SiO₂ film 4, reactive ion etching (RIE) with fluorine-containing etching gas is used.

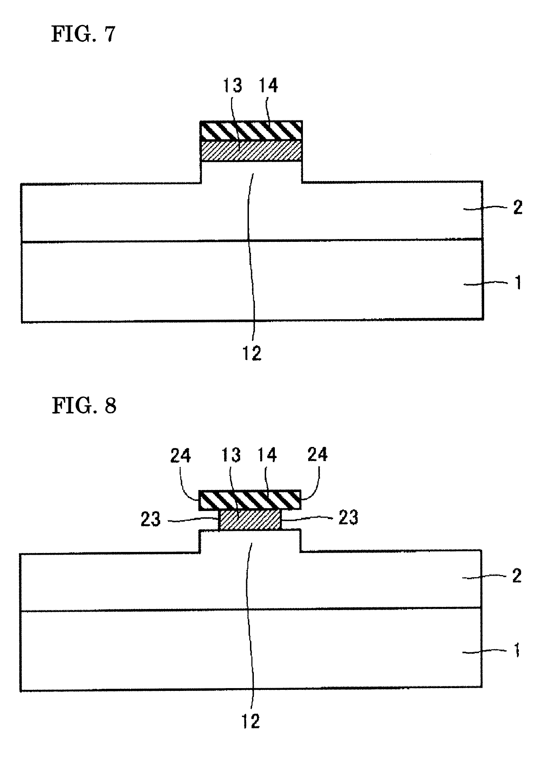

Then, the resist film 5 is removed by wet etching or the like. As a result, a structure as shown in Fig. 6 is obtained. Then, the Al film 3 and the GaN-based semiconductor layer 2 are partially removed by etching using the mask layer 14 composed of SiO₂ as a mask. In this etching step, the Al film 3 and the GaN-based semiconductor layer 2 are partially removed by RIE using chlorine-containing etching gas. As a result, a ridge portion 12 is formed as a protrusion including the Al film 13 and a portion of the GaN-based semiconductor layer 2 below the mask layer 14. As a result, a structure as shown in Fig. 7 can be formed. The height of the ridge portion 12 in protrusion portion (the height from the flat upper surface of the GaN-based semiconductor layer 2 adjacent to the ridge portion 12 to the upper surface of the ridge portion 12) can be arbitrarily determined by controlling a process condition such as the processing time of the etching.

Next, as shown in Fig. 1, the step (S60) of retracting the side walls of the first film is performed. In this step (S60), any etching method can be used under a condition in which the etching rate of the Al film 13 as the first film is larger than that of the mask layer 14 composed of the SiO₂ film as the second film. For example, when a substrate having the structure shown in Fig. 7 is immersed in an aqueous alkali solution (e.g., Semico Clean 23 manufactured by Furuuchi Chemical Corporation), the side walls of the Al film 13 can be partially removed. In this step, the position of the side wall 23 of the Al film 13 is retracted inward of the position of the side wall 24 of the mask layer 14. As a result, a structure as shown in Fig. 8 is formed. The amount of retract of the side wall 23 of the Al film 13 from the side wall 24 of the mask layer 14 (the distance between the side wall 24 of the mask layer 14 and the side wall 23 of the Al film 13) may be preferably 0.05 µm to 1 µm, more preferably 0.1 µm to 0.5 µm.

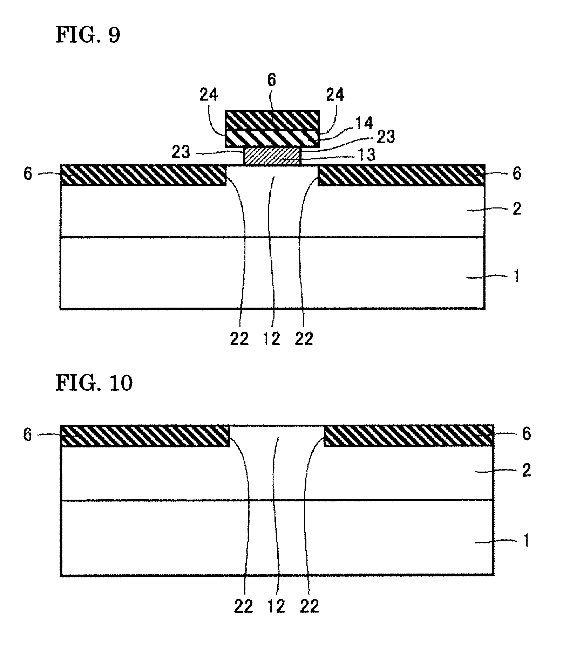

Next, as shown in Fig. 1, a step (S70) of forming a third film is performed. In this step (S70), a SiO₂ film 6 is formed as the third film on the side wall of the ridge portion 12, the upper surface of the GaN-semiconductor layer 2 excluding the ridge portion 12, and the upper surface of the mask layer 14. As a result, a structure as shown in Fig. 9 is formed. Here, the thickness of the SiO₂ film 6 as a protection film can be, for example, 0.05 µm to 0.5 µm.

As a method for forming the SiO₂ film 6, any method, such as the EB evaporation method, sputter deposition method, or the like, can be used. Since the position of the side wall 23 of the Al film 13 is retracted from the position of the side wall 24 of the mask layer 14, the SiO₂ film 6 is not formed on the side wall 23 of the Al film 13.

Next, as shown in Fig. 1, the liftoff step (S80) is performed. In this step (S80), a sample having a structure as shown in Fig. 9 is immersed in an aqueous alkali solution (e.g., Semico Clean 23 manufactured by Furuuchi Chemical Corporation). As a result, the Al film 13 is selectively etched with the aqueous alkali solution, and thus the Al film 13 is removed. At the same time, the mask layer 14, which is composed of a SiO₂ film and disposed on the Al film 13, and the SiO₂ film 6, which is formed on the mask layer 14, are removed with the removal of the Al film 13. As a result, a structure as shown in Fig. 10 is obtained. As seen from Fig. 10, the SiO₂ film 6 is maintained to be formed on the side wall of the ridge portion 12. Also, as seen from the above-described steps, the Al film 13 is used as the mask for forming the ridge portion 12 as well as used as the liftoff mask for removing a portion of the SiO₂ film 6, which is disposed on the ridge portion 12. Therefore, the position of the upper surface of the ridge portion 12 substantially accurately overlaps the region where the SiO₂ film 6 is removed by the liftoff process, thereby causing no deviation in the positional relationship therebetween. Therefore, a semiconductor device having a precise ridge structure can be formed.

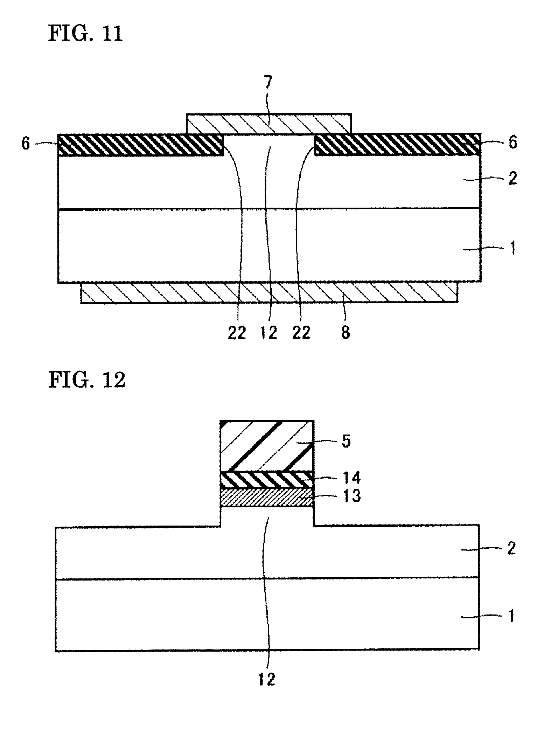

Next, as shown in Fig. 1, a step (S90) of forming an electrode is performed. More specifically, as shown in Fig. 11, an electrode 7 is formed at a position in contact with the upper surface of the ridge portion 12, and another electrode 8 is formed on the rear face of the substrate 1 (the rear face opposite to the front surface on which the GaN-based semiconductor layer 2 is formed). As a method of forming the electrodes 7 and 8, a generally known method such as a liftoff process can be used. For example, a resist film having an opening pattern is formed in a region in which the electrode 7 is to be formed and which covers the ridge portion, and a conductor film for the electrode 7 is formed on the resist film. Then, the resist film is removed by wet etching to form the electrode. Similarly, the method of forming the electrode 8 includes forming a mask layer, forming a conductor film on the mask, and liftoff by wet etching.

As seen from Fig. 11, the electrode 7 is formed to have a width larger than the width (the distance between the side walls of the ridge portion 12) of the upper surface of the ridge portion 12. That is, the electrode 7 extends from the upper surface of the ridge portion 12 to the SiO₂ film 6. Therefore, in the case where the upper surface of the ridge portion 12 is very narrow, even when the formation position of the electrode 7 varies to some extent, the electrode 7 can be securely connected to the upper surface of the ridge portion 12.

After the above-described steps, the substrate 1 is divided into individual chips using a dicing saw to produce a semiconductor device according to the present invention.

As a material of the mask layer 14, any one of silicon monoxide (SiO), silicon nitride (SiN), zirconium oxide (ZrO₂), tantalum oxide (Ta₂O₃), lanthanum oxide (La₂O₅), cerium oxide (CeO₃), and hafnium oxide (HfO₂), or two or more of these materials may be used instead of SiO₂. In addition, instead of the SiO₂ film 6, any one of a silicon monoxide film (SiO film), a silicon nitride film (SiN film), a zirconium oxide film (ZrO₂ film), a tantalum oxide film (Ta₂O₃ film), a lanthanum oxide film (La₂O₅ film), a cerium oxide film (CeO₃ film), and a hafnium oxide film (HfO₂ film), or a composite film of two or more of these films may be used.

### (Embodiment 2)

Figure 12 is a schematic sectional view for illustrating a method for manufacturing a compound semiconductor device according to Embodiment 2 of the present invention. The method for manufacturing a compound semiconductor device according to Embodiment 2 of the present invention is described with reference to Fig. 12.

The method for manufacturing a compound semiconductor device according to Embodiment 2 of the present invention basically includes the same steps as those of the method for manufacturing a compound semiconductor device described with reference to Figs. 1 to 11, but a layer used as a mask for forming the ridge portion 12 is different. Specifically, in the method for manufacturing a compound semiconductor device according to Embodiment 2 of the present invention, the same steps as the steps (S10) to (S40) of the manufacturing method shown in Fig. 1 are performed. As a result, a structure as shown in Fig. 4 is obtained. Then, like in Embodiment 1 described above, the SiO₂ film 4 is partially removed by RIE with fluorine-containing etching gas using the resist film 5 as a mask to produce a structure as shown in Fig. 5.

Next, unlike in Embodiment 1, in the method for manufacturing a compound semiconductor device according to Embodiment 2, the resist film 5 is not removed, and the Al film 3 and the GaN-based semiconductor layer 2 are etched. Specifically, the Al film 3 and the GaN-based semiconductor layer 2 are partially removed by RIE with chlorine-containing etching gas using the resist film 5 and the mask layer 14 as a mask. As a result, a structure as shown in Fig. 12 is formed.

After the ridge portion 12 is formed, the resist film 5 is removed by wet etching or the like. Then, the same steps as the steps (S60) to (S90) of Embodiment 1 described above are performed to produce a compound semiconductor device as shown in Fig. 11.

### (Embodiment 3)

A method for manufacturing a compound semiconductor device according to Embodiment 3 of the present invention basically has the same configuration as that of the method for manufacturing a compound semiconductor device according to Embodiment 1 of the present invention shown in Figs. 1 to 11. However, the etchant used in the step (S60) of retracting the side wall of the first film and the liftoff step (S80) is not an aqueous alkali solution but is a mixed acid containing phosphoric acid, nitric acid, acetic acid, and water. As the mixed acid, for example, a mixed acid with a composition containing 80% by mass of phosphoric acid, 5% by mass of nitric acid, 10% by mass of acetic acid, and the balance including water can be used. In this case, the same effect as in Embodiment 1 of the present invention can be obtained.

When the mixed acid is used as described above, as a material of the mask layer 14, any one of silicon monoxide (SiO), silicon nitride (SiN), zirconium oxide (ZrO₂), tantalum oxide (Ta₂O₃), lanthanum oxide (La₂O₅), cerium oxide (CeO₃), and hafnium oxide (HfO₂), or two or more of these materials may be used instead of SiO₂. In addition, instead of the SiO₂ film 6, any one of a SiO film, a SiN film, a ZrO₂ film, a Ta₂O₃ film, a La₂O₅ film, a CeO₃ film, and a HfO₂ film, or a composite film of two or more of these films may be used.

When the mixed acid is used as described above, under a condition in which the resist film 5 is not removed as shown in Fig. 12, the Al film 3 and the GaN-based semiconductor layer 2 may be etched.

### (Embodiment 4)

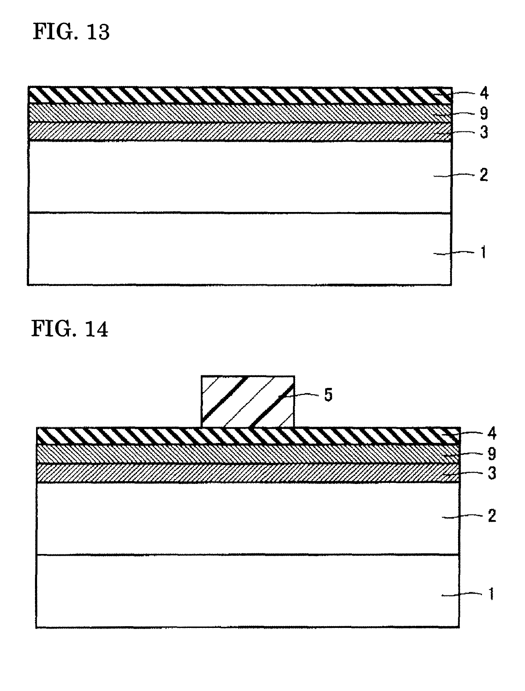

Figures 13 to 19 are schematic sectional views for illustrating each of the steps of a method for manufacturing a compound semiconductor device according to Embodiment 4 of the present invention. The method for manufacturing a compound semiconductor device according to Embodiment 4 of the present invention is described with reference to Figs. 13 to 19.

The method for manufacturing a compound semiconductor device according to Embodiment 4 of the present invention basically includes the same steps as those of the method for manufacturing a compound semiconductor device described with reference to Figs. 1 to 11, but is different in that a film (Au film 9 (refer to Fig. 13)) composed of gold is formed as a coating film on the Al film 3 before the SiO₂ film 4 is formed as the second film after the Al film 3 is formed as the first film. The method is described in detail below.

First, like in the method for manufacturing a compound semiconductor device according to Embodiment 1 of the present invention, a step (S10) (refer to Fig. 1) of forming a GaN-based semiconductor layer is performed. In this step (S10), as shown in Fig. 13, a GaN-based semiconductor layer 2 is formed on the front surface of a substrate 1 using an epitaxial growth method.

Next, as shown in Fig. 1, a step (S20) of forming a first film is performed. In this step (S20), an Al film 3 (refer to Fig. 13) is formed as the first film on the GaN-based semiconductor layer 2. As a method for forming the Al film 3, any desired method, such as an EB evaporation method, a sputtering method, or the like, can be used. The thickness of the Al film 3 can be, for example, 0.3 µm.

Next, a step of forming a coating film is performed. In this coating film forming step, an Au film 9 (refer to Fig. 13) is formed as the coating film on the Al film 3. The Au film 9 can be formed by any desired method. The thickness of the Au film 9 can be, for example, 0.005 µm to 0.05 µm (for example, about 0.01 µm).

Next, as shown in Fig. 1, a step (S30) of forming a second film is performed. In this step (S30), a SiO₂ film 4 is formed as the second film on the Au film 9. As a result, a structure as shown in Fig. 13 is obtained.

Next, the same step as the patterning step (S40) in the manufacturing method shown in Fig. 1 is performed. As a result, as shown in Fig. 14, a resist film 5 having a predetermined pattern is formed on the SiO₂ film 4. The planar shape of the resist film 5 corresponds to the planar shape of the upper surface of a ridge portion described below.

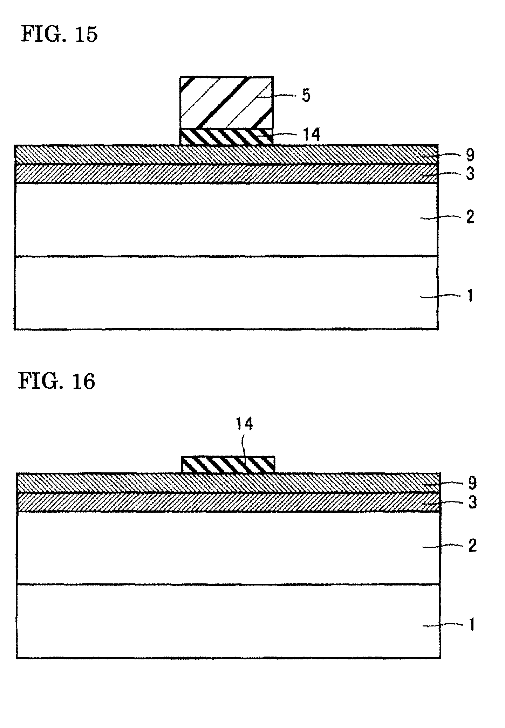

Next, the same step as that (S50) of forming a protrusion in the manufacturing method shown in Fig. 1 is performed. In this step (S50), the SiO₂ film 4 is partially removed by etching using the resist film 5 as a mask to form a structure as shown in Fig. 15. Namely, a mask layer 14 composed of the SiO₂ film 4 (refer to Fig. 14) is formed below the resist film 5 by etching. The planar shape of the mask layer 14 is the same as that of the resist film 5. In etching the SiO₂ film 4, reactive ion etching (RIE) with fluorine-containing etching gas is used.

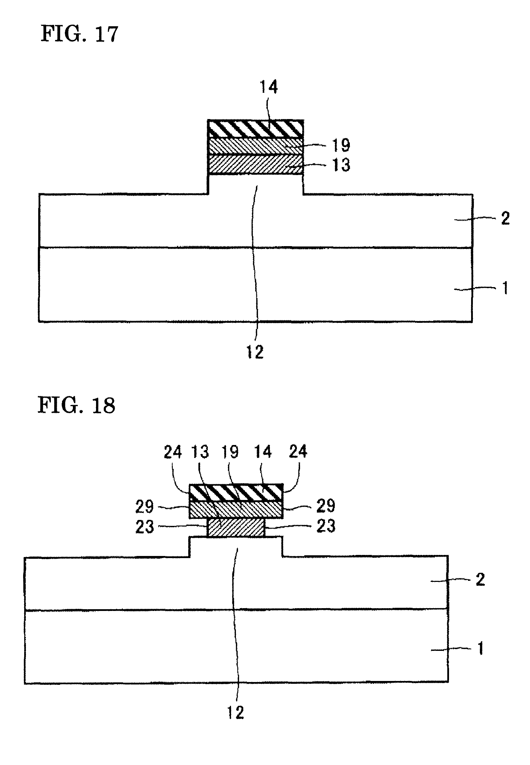

Then, the resist film 5 is removed by wet etching. As a result, a structure as shown in Fig. 16 is obtained. Then, the Au film 9, the Al film 3, and the GaN-based semiconductor layer 2 are partially removed by etching using the mask layer 14 as a mask. In this etching step, the Au film 9, the Al film 3, and the GaN-based semiconductor layer 2 are partially removed by RIE using chlorine-containing etching gas. As a result, as shown in Fig. 17, a ridge portion 12 is formed as a protrusion including, below the mask layer 14, the Au film 19, the Al film 13, and a portion of the GaN-based semiconductor layer 12.

In the step (S50), the mask 14 is formed, and the Au film 9 is etched continuously, when the Al film 3 and the GaN-based semiconductor layer 2 are etched. However, the timing of etching of the Au film 9 may be different. For example, in the etching step of forming the mask layer 14 described with reference to Fig. 15, the Au film may be continuously partially removed by etching using the resist film 5 as a mask to form the Au film 19 having the same pattern as that of the resist film 5. In this case, in the step of partially etching the Al film 3 and the GaN-based semiconductor layer 2 described with reference to Fig. 17, the Au film 9 is not etched.

Next, the same step as that (S60) of retracting the side walls of the first film in the manufacturing method shown in Fig. 1 is performed. In this step (S60), any etching method can be used under a condition in which the etching rate of the Al film 13 as the first film is larger than that of the mask layer 14 composed of the SiO₂ film as the second film (and preferably the Au film 19). For example, when the substrate having the structure shown in Fig. 17 is immersed in an aqueous alkali solution (e.g., Semico Clean 23 manufactured by Furuuchi Chemical Corporation), the side wall of the Al film 13 can be partially removed. In this step, the position of the side walls 23 of the Al film 13 is retracted inward from the position of the side walls 24 of the mask layer 14 and the side wall 29 of the Au film 19. As a result, a structure as shown in Fig. 18 is formed.

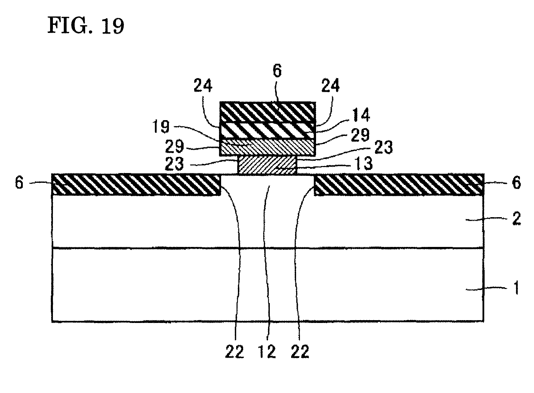

Next, the same step as that (S70) of forming a third film in the manufacturing method shown in Fig. 1 is performed. In this step (S70), as shown in Fig. 19, a SiO₂ film 6 is formed as the third film on the side wall of the ridge portion 12, the upper surface of the GaN-semiconductor layer 2 excluding the ridge portion 12, and the upper surface of the mask layer 14.

As a method for forming the SiO₂ film 6, any method, such as the EB evaporation method, sputter deposition method, or the like, can be used. Since the position of the side wall 23 of the Al film 13 is retracted from the position of the side wall 24 of the mask layer 14, the SiO₂ film 6 is not formed on the side wall 23 of the Al film 13.

Next, the same step as the liftoff step (S80) in the manufacturing method shown in Fig. 1, is performed. In this step (S80), a sample having a structure as shown in Fig. 19 is immersed in an aqueous alkali solution (e.g., Semico Clean 23 manufactured by Furuuchi Chemical Corporation). As a result, the Al film 13 is selectively etched with the aqueous alkali solution, and thus the Al film 13 is removed. At the same time, the mask layer 14 and the Au film 19 disposed on the Al film 13, and the SiO₂ film 6 formed on the mask layer 14 are removed with the removal of the Al film 13. As a result, a structure as shown in Fig. 10 is obtained. Then, the same step as that (S90) (see Fig. 1) in the above-described embodiment is performed to produce a compound semiconductor device as shown in Fig. 11.

In the step (S60) of retracting the side wall of the first film and the liftoff step (S80), the mixed acid containing phosphoric acid, nitric acid, acetic acid, and water, which is described above in Embodiment 3 of the present invention, may be used instead of the aqueous alkali solution as an etchant.

Although, in Embodiment 4 described above, the Au film 9 is formed as the coating film on the Al film 3, a Ti film 9 may be formed using titanium instead of gold. That is, the Ti film 9, not the Au film 9, is formed as the coating film between the Al film 3 as the first film and the SiO₂ film 4 as the second film. By using the Ti film 9 as the coating film, adhesion between the Al film 3 as the first film and the coating film, and adhesion between and the SiO₂ film 4 as the second film and the coating film are further improved as compared with the case in which the Au film 9 is used. Namely, it is possible to reduce the possibility that in dry etching using as a mask the Al film 3 as the first film, the coating film, and the SiO₂ film 4 as the second film, the ends of the formed ridge portion are roughened due to roughening of the ends of the mask. In addition, in the step of partially removing the Ti film 9, the Al film 3, and the GaN-based semiconductor layer 2 by RIE with the chlorine-containing etching gas, the possibility is reduced, which is that fine remains of the Ti film 9 remain on the surface of the etched ridge portion. Therefore, fine remains of the Ti film 9 adhering to the ridge portion are unlikely to function as a fine mask and influence the etching, thereby suppressing a decrease in yield of a semiconductor device. When titanium is used for the coating film, of course, the coating film becomes the Ti film 19 after the liftoff step.

Even when the Ti film 9 is used as the coating film instead of the Au film 9, the other conditions such as the deposition method, the thickness of the film, the thicknesses of the Al film 3 as the first film and the SiO₂ film 4 as the second film, and the like may be the same as those in the case in which the Au film 9 is used as the coating film.

In the above-described Embodiments 1 to 4, a liftoff process may be used in the step (S30) of forming the second film and the patterning steep (S40). Specifically, a resist film having an opening pattern is formed on the Al film 3 as the first film so that the opening region of the pattern corresponds to the region where the ridge portion 12 is to be formed, and the SiO₂ film 4 as the second film is formed on the resist film. In this step, a portion of the SiO₂ film 4 (serving as the mask layer 14) is formed in contact with the Al film 3 within the opening pattern. Then, the resist film is removed by wet etching to partially remove the SiO₂ film 4 together with the resist film, leaving the portion which serves as the mask layer 14. The structure as shown in Fig. 6 may be formed by this method.

Although there are overlaps with the above-described embodiments, the characteristic features of the present invention are summarized below.

In a method for manufacturing a semiconductor device according to the present invention, the following steps are carried out. First, a step (a step (S10) of forming a GaN-based semiconductor layer) of preparing a gallium nitride-based semiconductor layer (GaN-based semiconductor layer 2) which constitutes a semiconductor device is carried out. A step (a step (S20) of forming a first film) of forming a first film (Al film 3) on the GaN-based semiconductor layer 2 is carried out. A step (a step (S30) of forming a second film and a patterning step (S40)) of forming a second film (mask layer 14) having a pattern and composed of a material having a lower etching rate with an alkaline etchant than that of the material constituting the Al film 3 is carried out. A step (a step (S50) of forming a protrusion) of partially removing by etching the Al film 3 and the GaN-based semiconductor layer 2 using the second film (mask layer 14) as a mask to form a ridge portion 12 in the GaN-based semiconductor layer 2 in a region below the second film (mask layer 14) is carried out.

A step (a step (S60) of retracting the side walls of the first film) of removing the ends of the Al film 13, which are positioned on the ridge portion 12 (see Fig. 7), by etching with an alkaline etchant to retract the end position of the Al film 13 (the position of the side walls 23) from the end position of the mask layer 14 (the position of the side walls 24) is carried out. A step (a step (S70) of forming a third film) of forming a protection film (SiO₂ film 6) composed of a material having a lower etching rate with an alkaline etchant than that of the material constituting the Al film 3 or 13 on the side surfaces of the ridge portion 12 and on the upper surface of the mask layer 14 is carried out. A step (a liftoff step (S80)) of removing the Al film 13 by etching with an alkaline etchant to remove the mask layer 14 and a portion of the SiO₂ film 6 formed on the upper surface of the mask layer 14 is carried out. A step (a step (S90) of forming an electrode) of forming an electrode 7 on the surface of the ridge portion 12 exposed by removing the Al film 13 is carried out.

As a result, the mask layer 14 is used as the mask for forming the ridge portion 12, and at the same time, the mask layer 14 (the SiO₂ film 6 as the protection film is formed on the upper surface thereof) is removed by removing the Al film 13 in order to expose the upper surface of the ridge portion 12. Therefore, the SiO₂ film 6 can be securely removed from the upper surface of the ridge portion 12. Thus, the possibility of deviation between the position of the upper surface of the ridge portion 12 and the position of a portion of the SiO₂ film 6, which is to be removed, can be decreased as compared with the case in which in order to remove the SiO₂ film 6 from the upper surface of the ridge portion 12, a new resist pattern is formed separately from the mask layer 14 used for forming the ridge portion 12. Therefore, it is possible to prevent the occurrence of the problem that poor connection between the electrode 7 and the upper surface of the ridge portion 12 occurs due to deviation between the position of the upper surface of the ridge portion 12 and the position of a portion of the SiO₂ film, which is to be removed, thereby causing deterioration of the characteristics and malfunction of a semiconductor device. Consequently, it is possible to suppress an increase in manufacturing cost due to a decrease in manufacturing yield of a semiconductor device.

In addition, since the side wall 23 of the Al film 13 is retracted from the side wall 24 of the mask layer 14 before the SiO₂ film 6 as the protection film is formed, it is possible to decrease the possibility that, when the SiO₂ film 6 is formed, the SiO₂ film 6 is partially formed on the side wall 23 of the Al film 13. Therefore, it is possible to decrease the event probability of the problem that, when the Al film 13 is removed, the Al film 13 cannot be sufficiently removed due to the formation of a portion of the SiO₂ film 6 on the side wall 23 of the Al film 13 (therefore, the mask layer 14 and the SiO₂ film 6 formed on the upper surface of the mask layer 14 cannot be sufficiently removed). Thus, it is possible to decrease the event probability of malfunction of a semiconductor device due to the above-described problem. Consequently, it is possible to suppress an increase in manufacturing cost due to a decrease in manufacturing yield of a semiconductor device.

Further, since the mask layer 14 is composed of a material (SiO₂) having a lower etching rate with an alkaline etchant than that of the material (Al) constituting the Al film 13, there is no need for additional treatment such as heat treatment for selectively etching the Al film 13 over the mask layer 14. Therefore, the number of steps for manufacturing a semiconductor device can be decreased as compared with the case in which the additional treatment is performed. As a result, the manufacturing cost of a semiconductor device can be decreased.

In a method for manufacturing a semiconductor device according to the present invention, the following steps are carried out. First, a step (a step (S10) of forming a GaN-based semiconductor layer) of preparing a gallium nitride-based semiconductor layer (GaN-based semiconductor layer 2) which constitutes a semiconductor device is carried out. A step (a step (S20) of forming a first film) of forming a first film (Al film 3) on the GaN-based semiconductor layer 2 is carried out. A step (a step (S30) of forming a second film and a patterning step (S40)) of forming a second film (mask layer 14) having a pattern and composed of a material having a lower etching rate with a mixed acid containing phosphoric acid, nitric acid, acetic acid, and water than that of the material constituting the Al film 3 is carried out. A step (a step (S50) of forming a protrusion) of partially removing by etching the Al film 3 and the GaN-based semiconductor layer 2 using the second film (mask layer 14) as a mask to form a ridge portion 12 in the GaN-based semiconductor layer 2 in a region below the second film (mask layer 14) is carried out.

A step (a step (S60) of retracting the side walls of the first film) of removing the ends of the Al film 13, which are positioned on the ridge portion 12, by etching with a mixed acid to retract the end positions of the Al film 13 (the positions of the side walls 23) from the end positions of the mask layer 14 (the positions of the side walls 24) is carried out. A step (a step (S70) of forming a third film) of forming a protection film (SiO₂ film 6) composed of a material having a lower etching rate with a mixed acid than that of the material constituting the Al film 3 or 13 on the side surfaces of the ridge portion 12 and on the upper surface of the mask layer 14 is carried out. A step (a liftoff step (S80)) of removing the Al film 13 by etching with a mixed acid to remove the mask layer 14 and a portion of the SiO₂ film 6 formed on the upper surface of the mask layer 14 is carried out. A step (a step (S90) of forming an electrode) of forming an electrode 7 on the surface of the ridge portion 12 exposed by removing the Al film 13 is carried out.

As a result, the mask layer 14 is used as the mask for forming the ridge portion 12, and at the same time, the mask layer 14 (the SiO₂ film 6 is formed on the upper surface thereof) is removed by removing the Al film 13 in order to expose the upper surface of the ridge portion 12. Therefore, the SiO₂ film 6 can be securely removed from the upper surface of the ridge portion 12. Thus, the possibility of deviation between the position of the upper surface of the ridge portion 12 and the position of a portion of the SiO₂ film 6, which is to be removed, can be decreased as compared with the case in which in order to remove the SiO₂ film 6 from the upper surface of the ridge portion 12, a new resist pattern is formed separately from the mask layer 14 used for forming the ridge portion 12. Therefore, it is possible to prevent the occurrence of the problem that poor connection between the electrode 7 and the upper surface of the ridge portion 12 occurs due to deviation between the position of the upper surface of the ridge portion 12 and the position of a portion of the SiO₂ film 6, which is to be removed, thereby causing deterioration of the characteristics and malfunction of a semiconductor device. Consequently, it is possible to suppress an increase in manufacturing cost due to a decrease in manufacturing yield of a semiconductor device.

In addition, since the side wall 23 of the Al film 13 is retracted inwardly from the side wall 24 of the mask layer 14 before the SiO₂ film 6 is formed, it is possible to decrease the possibility that when the SiO₂ film 6 is formed, the SiO₂ film 6 is partially formed on the side wall 23 of the Al film 13. Therefore, it is possible to decrease the event probability of the problem that when the Al film 13 is removed, the Al film 13 cannot be sufficiently removed due to the formation of a portion of the SiO₂ film 6 on the side wall 23 of the Al film 13. Thus, it is possible to the event probability of malfunction of a semiconductor device due to the above-described problem. Consequently, it is possible to suppress an increase in manufacturing cost due to a decrease in manufacturing yield of a semiconductor device.

Further, since the mask layer 14 is composed of a material (SiO₂) having a lower etching rate with a mixed acid than that of the material (Al) constituting the Al film 13, there is no need for additional treatment such as heat treatment for selectively etching the Al film 13 over the mask layer 14. Therefore, the number of steps for manufacturing a semiconductor device can be decreased as compared with the case in which the additional treatment is performed. As a result, the manufacturing cost of a semiconductor device can be decreased.

In the above-described method for manufacturing a semiconductor device, a liftoff process may be used in the step of forming the mask layer 14 as the second film (the step (S30) of forming the second film and the patterning step (S40)). In this case, the mask layer 14 having a predetermined pattern and being composed of a material which is difficult to etch can be formed.. Therefore, the degree of freedom of selection of a material used for the mask layer 14 can be increased.

In the above-described method for manufacturing a semiconductor device, the material constituting the first film is aluminum. As a material of the mask layer 14, at least one selected from the group consisting of silicon dioxide, silicon monoxide, silicon nitride, zirconium oxide, tantalum oxide, lanthanum oxide, cerium oxide, and hafnium oxide may be used. In addition, as a material constituting the protection film corresponding to the SiO₂ film 6, at least one selected from the group consisting of silicon monoxide, silicon nitride, zirconium oxide, tantalum oxide, lanthanum oxide, cerium oxide, and hafnium oxide may be used instead of the above-described silicon dioxide.

In this case, aluminum, which is a metal having a high etching rate with an alkaline etchant or a mixed acid as compared with the mask layer 14 composed of an oxide and the protection film composed of the SiO₂ film 6, may be used as the material of the first film corresponding to the Al film 3. This allows the method for manufacturing a semiconductor device according to the present invention to be securely performed.

The method for manufacturing a compound semiconductor device may further include a step of forming a coating film (Au film 9 or Ti film 9) on the first film(Al film 3) after the step (S20) of forming the first film and before the step (S30) of forming the second film as shown in Fig. 13. Also, the method for manufacturing a compound semiconductor device may further include a step of partially removing the coating film (Au film 9 or Ti film 9) so that the coating film has the same pattern as that of the second film (mask layer 14) as shown in Fig. 17. As a result, an Au film 19 or Ti film 19 having the same pattern as the mask layer 14 is formed as shown in Fig. 17. In the step (liftoff step (S80)) of removing the protection film (SiO₂ film 6), the Au film 19 or Ti film 19 as the coating film, which is disposed on the Al film 3, is also removed. The step of partially removing the coating film (Au film 9 or Ti film 9) may be performed in succession to the step of forming the ridge portion 12 as shown in Fig. 17, alternatively may be performed in succession to the step of forming the second film having a pattern (in succession to etching for forming the mask layer 14 in the patterning step (S40)) before the step of forming the ridge portion 12.

In this case, a surface of the Al film 3 as the first film is covered with the Au film 9 or Ti film 9, thereby preventing damage to the surface of the Al film 3 in the step of forming the second film (SiO₂ film 4). In particular, therefore, in a configuration in which the ridge portion 12 is narrowed, the damage to the surface of the Al film 3 (for example, the occurrence of irregularity due to the step of forming the second film) makes it difficult to form the ride portion 12 having a shape and size according to design. Therefore, it is particularly effective to protect the surface of the Al film 3 by forming the Au film 9 or Ti film 9.

The embodiments disclosed here should be considered to be illustrative and not limitative in any aspect. The scope of the present invention is indicated by the claims, not the description above, and intended to include meaning equivalent to the claims and any modification within the scope. Industrial Applicability

The present invention can be applied to, particularly, a method for manufacturing a semiconductor device having a ridge portion formed in a gallium nitride-based semiconductor layer.

## Claims

1. A method for manufacturing a semiconductor device comprising:
a step of preparing a gallium nitride-based semiconductor layer which constitutes a semiconductor device;
a step of forming a first film on the gallium nitride-based semiconductor layer;
a step of forming a second film having a pattern and composed of a material having a lower etching rate with an alkaline etchant than that of the material constituting the first film;
a step of partially removing the first film and the gallium nitride-based semiconductor layer by etching using the second film as a mask to form a ridge portion in the gallium nitride-based semiconductor layer in a region below the second film;
a step of removing the ends of the first film, which are positioned on the ridge portion, by etching with the alkaline etchant to retract the end positions of the first film from the end positions of the second film;
a step of forming a protection film composed of a material having a lower etching rate with the alkaline etchant than that of the material constituting the first film, on the side surfaces of the ridge portion and on the upper surface of the second film;
a step of removing the first film by etching with the alkaline etchant to remove the second film and the protection film formed on the upper surface of the second film; and
a step of forming an electrode on the surface of the ridge portion exposed by removing the first film.

2. A method for manufacturing a semiconductor device comprising:
a step of preparing a gallium nitride-based semiconductor layer which constitutes a semiconductor device;
a step of forming a first film on the gallium nitride-based semiconductor layer;
a step of forming a second film having a pattern and composed of a material having a lower etching rate with a mixed acid containing phosphoric acid, nitric acid, acetic acid, and water than that of the material constituting the first film;
a step of partially removing the first film and the gallium nitride-based semiconductor layer by etching using the second film as a mask to form a ridge portion in the gallium nitride-based semiconductor layer in a region below the second film;
a step of removing the ends of the first film, which are positioned on the ridge portion, by etching with the mixed acid to retract the end positions of the first film from the end positions of the second film;
a step of forming a protection film composed of a material having a lower etching rate with the mixed acid than that of the material constituting the first film, on the side surfaces of the ridge portion and on the upper surface of the second film;
a step of removing the first film by etching with the mixed acid to remove the second film and the protection film formed on the upper surface of the second film; and
a step of forming an electrode on the surface of the ridge portion exposed by removing the first film.

3. The method for manufacturing a semiconductor device according to Claim 1 or 2, wherein a liftoff process is used in the step of forming the second film.

4. The method for manufacturing a semiconductor device according to any one of Claims 1 to 3, wherein a material which constitutes the first film is aluminum.

5. The method for manufacturing a semiconductor device according to any one of Claims 1 to 4, further comprising, before the step of forming the second film after the step of forming the first film:
a step of forming a coating film on the first film; and
a step of partially removing the coating film so that the coating film has the same pattern as that of the second film,
wherein in the step of partially removing the protection film, the coating film disposed on the first film is also removed.

6. The method for manufacturing a semiconductor device according to Claim 5, wherein a material which constitutes the coating film is gold or titanium.

7. The method for manufacturing a semiconductor device according to any one of Claims 1 to 6, wherein a material which constitutes the second film is at least one selected from the group consisting of silicon dioxide, silicon monoxide, silicon nitride, zirconium oxide, tantalum oxide, lanthanum oxide, cerium oxide, and hafnium oxide.

8. The method for manufacturing a semiconductor device according to any one of Claims 1 to 7, wherein a material which constitutes the protection film is at least one selected from the group consisting of silicon dioxide, silicon monoxide, silicon nitride, zirconium oxide, tantalum oxide, lanthanum oxide, cerium oxide, and hafnium oxide.
